# EUROPEAN PATENT APPLICATION

(11) **EP 4 716 409 A1**
(43) Date of publication of application: **25.03.2026**
(21) Application number: 25193485.7
(22) Date of filing: 01.08.2025
(51) Int. Cl.: H10D 84/01, H10D 84/85, H10D 30/00, H10D 84/03

(54) **COMPLEMENTARY GATE CUT PLUGS FOR STRAIN OPTIMIZATION**

(30) Priority: 24.09.2024 US 202418894686
(71) Applicant: INTEL Corporation, Santa Clara, CA 95054 (US)
(72) Inventor: Chu, Tao, Portland OR, 97229 (US); Xu, Guowei, Portland, OR, 97229 (US); Chao, Robin, Portland, OR, 97209 (US); Zhang, Feng, Portland, OR, 97229 (US); Hung, Ting-Hsiang, Beaverton OR, 97007 (US); Lin, Chia-Ching, Portland OR, 97229 (US); Zhang, Yang, Rio Rancho, NM, 87124 (US); Zhang, Kan, Hillsboro, OR, 97123 (US); Yeung, Chun Wing, Portland, OR, 97229 (US); Jang, Minwoo, Portland OR, 97229 (US); Luo, Yanbin, Portland, OR, 97229 (US); Packan, Paul, Hillsboro OR, 97124 (US); Lin, Chung-Hsun, Portland, OR, 97229 (US); Murthy, Anand, Portland, OR, 97229 (US)
(74) Representative: Samson & Partner Patentanwälte mbB

(57) **Abstract**

An integrated circuit (IC) device having complementary dielectric plugs separating gate electrodes. An IC device includes a first gate-cut plug of silicon and nitrogen between and in contact with two gate structures of transistors of a first conductivity type and a second gate-cut plug between and in contact with two gate structures of transistors of a second conductivity type, complementary to the first conductivity type, and the second gate-cut plug has within a liner of silicon and nitrogen either an airgap or a dielectric of silicon and oxygen. Pairs of gate structures of transistors having both of the first and second conductivity types are separated by first and second gate-cut plugs.

## Description

### BACKGROUND

Extensive process development work has improved n- and p-type charge-carrier mobilities by providing strain to crystalline transistor channels. Significantly, longitudinal strains have been introduced to improve available drive currents. However, transistors of complementary conductivity types also require complementary channel strains to improve mobilities of both carrier types, and various materials, structures, or processing operations that affect channel strains will likely reduce performance of transistors of one conductivity type or the other. Such degenerative strains are especially likely as device dimensions are scaled down and transistors and channels of complementary conductivity types are packed more and more closely together.

Furthermore, processing methods for inducing channel strains (such as tensile or compressive forces exerted on channels by coupled source and drain bodies) may be affected by downstream operations that impact channels of one or both conductivity types. For example, replacements of, or cuts through, gates over channels of one or both conductivity types may diminish previously developed channel strains.

New techniques, structures, and materials are needed to maintain and improve complementary channel strains developed in non-planar transistors.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, 1C, 1D, 1E, 1F, and 1G illustrate plan and cross-sectional profile views of an integrated circuit (IC) device having gate plugs on and between gate structures, in accordance with some embodiments;
FIG. 2 is a flow chart of methods for forming dielectric gate-cut plugs that may provide complementary strains to adjacent transistor channels, in accordance with some embodiments;
FIGS. 3A, 3B, 3C, 3D, and 3E illustrate cross-sectional profile views of an IC device having complementary gate plugs between gate structures, at various stages of manufacture, at various stages of manufacture, in accordance with some embodiments;
FIG. 4 illustrates a diagram of an example data server machine employing an IC device having complementary gate plugs providing complementary strains between gate structures, in accordance with some embodiments; and
FIG. 5 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to maintain and improve complementary channel strains developed between non-planar transistors in integrated circuit (IC) devices.

Complementary longitudinal strains may be employed in complementary transistor channels to increase charge-carrier mobilities and corresponding drive currents. But adjacent transistor channels may be mechanically coupled, particularly as device dimensions are scaled down, and strains developed to benefit some channels may impair channels of a complementary conductivity type. Gate electrodes that span complementary channels may transmit degenerative strains. Gate-cut plugs (e.g., dielectric structures that fill cuts or gaps between decoupled gate electrodes) may transmit transverse strains between adjacent gate electrodes and corresponding transistor channels. Complementary transverse strains and complementary gate plugs may be required to optimize channel strains and improve conduction through complementary channels.

For example, conduction of n-type non-planar transistor channels may benefit from tensile longitudinal strain and from gate plugs of expansive materials that exert compressive transverse strain, but conduction of adjacent p-type non-planar transistors may be degraded by the same gate plugs. Gate plugs of expansive materials that exert compressive transverse strain on the adjacent p-type transistor channels may also transmit tensile longitudinal strain that reduce p-type channel conductivity. The operation of the complementary n- and p-type transistors may be improved by the use of complementary gate plugs. The gate plugs are complementary because the plugs are deployed in a scheme of counterpart pairs. First gate plugs on and between gate electrodes of n-type transistors are of a first material that improve performance by providing compressive transverse strains to gate electrodes and channels of n-type transistors. Second gate plugs on and between gate electrodes of p-type transistors are of a second material that provides tensile transverse strains (or at least checks or decouples the compressive transverse strains) to gate electrodes and channels of p-type transistors.

In many embodiments, first gate plugs on and between gate electrodes of n-type transistors include silicon and nitrogen (e.g., in dielectric structures of silicon nitride), which may transmit compressive strains between the gate electrodes. In some embodiments, second gate plugs on and between gate electrodes of p-type transistors include silicon and oxygen (e.g., in dielectric structures of silicon oxide), which may transmit tensile strains between the gate electrodes. In some such embodiments, the second gate plugs include a dielectric layer of silicon and nitrogen in contact with the gate electrodes and around the dielectric structures of silicon and oxygen. In some embodiments, second gate plugs on and between gate electrodes of p-type transistors include a dielectric layer of silicon and nitrogen around an air gap (e.g., a void or cavity containing vacuum or gas) and in contact with the gate electrodes, which may transmit tensile strains between the gate electrodes.

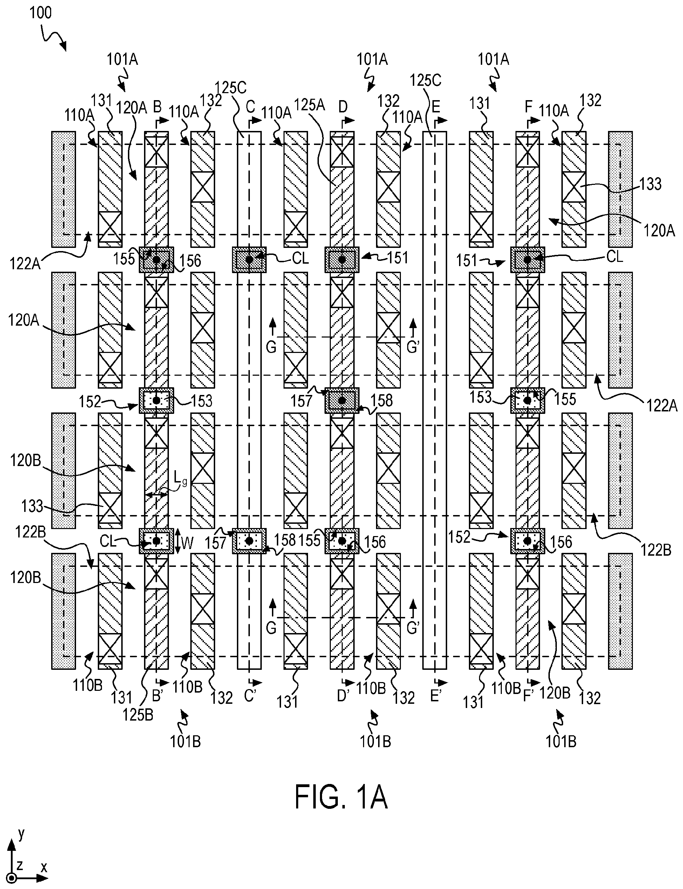

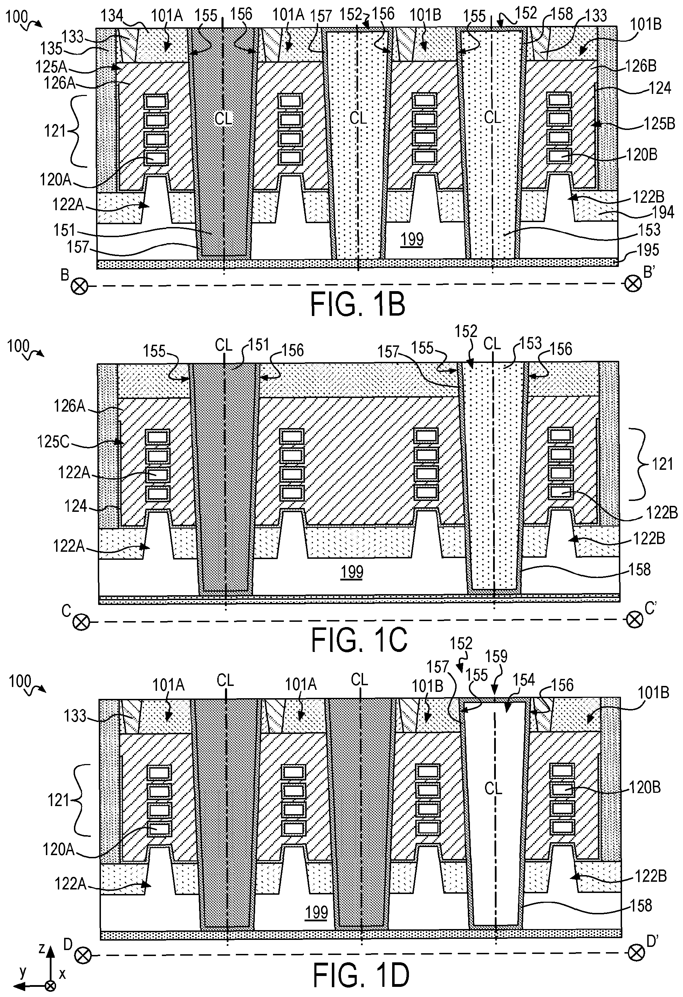

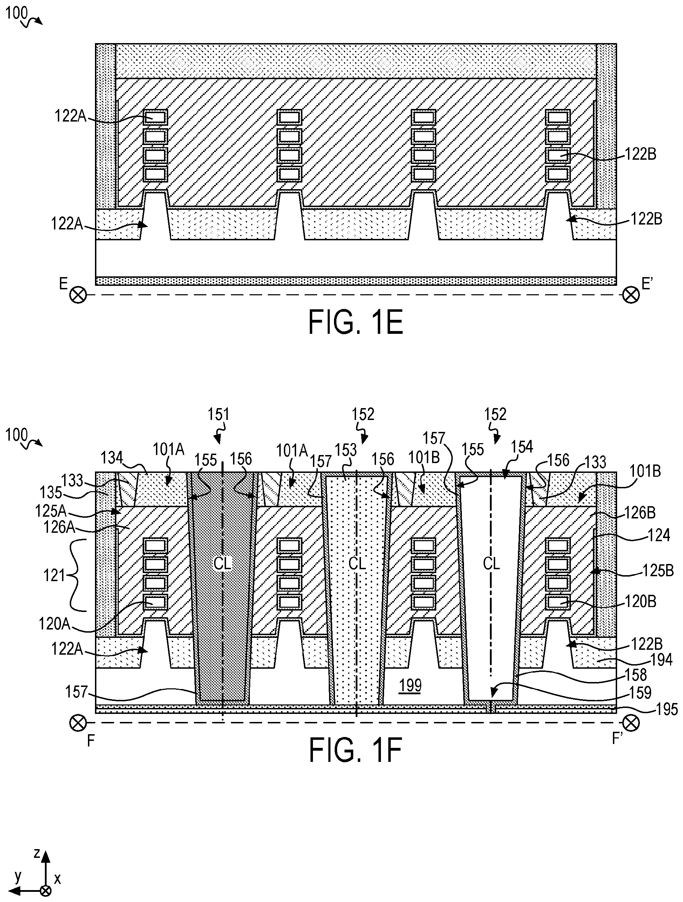

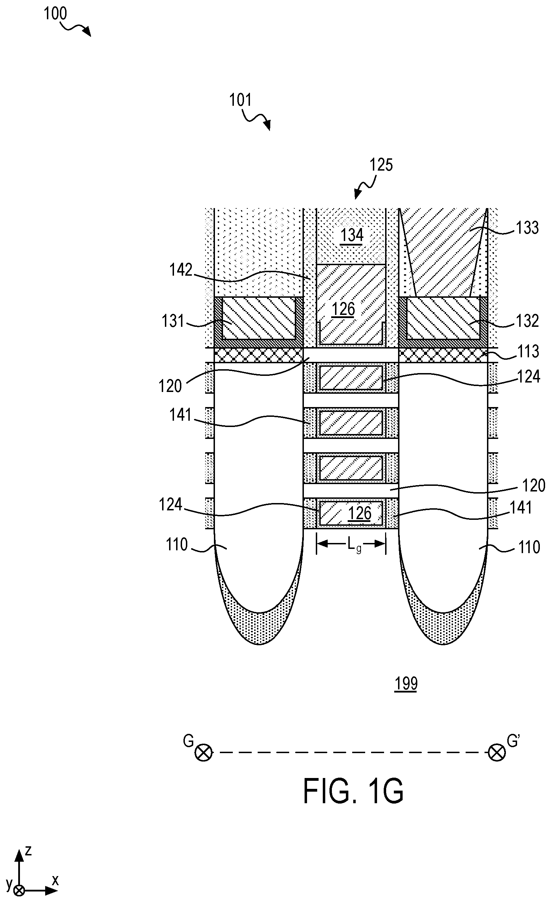

FIGS. 1A, 1B, 1C, 1D, 1E, 1F, and 1G illustrate plan and cross-sectional profile views of an IC device 100 having gate plugs 151, 152 on and between gate structures 125, in accordance with some embodiments. In many embodiments, gate plugs 151, 152 improve conductivity of, and increase conduction through, adjacent transistor channels 120A, 120B by providing compressive and/or tensile strain on channels 120A, 120B. Gate plugs 151, 152 are in contact with, and provide isolation between, gate structures 125, for example, as gate cut plugs 151, 152 in etches between and/or through metal gate structures 125 in metal-oxide-semiconductor (MOS) field-effect transistor (FET) structures 101. The orientation of y-z viewing planes B-B', C-C', D-D', E-E', and F-F' (through gate plugs 151, 152 and structures 125) and x-z viewing plane G-G' (through gate structures 125) of FIGS. 1B, 1C, 1D, 1E, 1F, and 1G, respectively, are shown in the x-y plan view of FIG. 1A.

FIG. 1A is a plan view of device 100 with structures at various elevations shown and some structures omitted, e.g., for illustrative purposes. IC device 100 includes an array of transistor structures 101 arranged in rows on semiconductor structures 122, which each include channels 120. Transistor structures 101 may be complementary structures 101A, 100B with channels 120A, 120B of complementary conductivity type (e.g., n- and p-type) coupling source and drain bodies 110A, 110B of corresponding type. Channels 120 are channel regions or channel structures in semiconductor structures 122, e.g., those portions of structures 122 between coupled source and drain bodies 110. In the example of FIG. 1A, NMOS transistor structures 100A include channels 120A coupling n-type source and drain bodies 110A, and PMOS transistor structures 100B include channels 120B coupling p-type source and drain bodies 110B. Source and drain bodies 110 are under and obscured by contact structures 131, 132, which couple transistor structures 101 at source and drain bodies 110 through vias 133 to an interconnect network over (e.g., in the positive z-dimension) structures 101. Other vias 133 on gate structures 125A, 125B couple transistor structures 101 to the interconnect network.

Channels 120 (and semiconductor structures 122 more broadly) may be of any suitable material(s) or structure(s), such as fins of semiconductor material in FinFET structures 101. In gate-all-around (GAA) FET structures 101, channels 120 may be channel material layers in vertical stacks, e.g., with multiple, vertically aligned channel layers in a single channel 120 in a single transistor structure 101. Channels 120 may be channel material layers of any suitable width, such as nanowire channels 120 (e.g., of very narrow width), nanosheet channels 120 (e.g., of relatively wide width), nanoribbon channels 120 (e.g., of any intermediate width), etc. Channels 120 may be channels 120A, 120B of complementary conductivity types (e.g., n- and p-type). In the example of FIG. 1A, multiple adjacent NMOS nanoribbon channels 120A extend in the x-directions, parallel with multiple adjacent PMOS nanoribbon channels 120B. The extents of semiconductor structures 122 and channels 120 are delineated with dashed borders. In some embodiments, structures 122 are continuous structures 122 that include multiple, connected channels 120. In many embodiments, structures 122 include multiple channels 120 but are discontinuous, e.g., at source and drain bodies 110. In some such embodiments, multiple channels 120 aligned on a common axis are from a same semiconductor structure 122, e.g., etched into separate channels 120 and transistor structures 101, for example, by fin cuts through the semiconductor structure 122.

The complementary conductivity types of channels 120A, 120B may be determined by or apparent from the material, structure, etc., of channels 120A, 120B, which may each have higher mobilities for complementary charge carriers. For example, NMOS channels 120A may have higher electron mobilities than do PMOS channels 120B, which may have higher hole mobilities than NMOS channels 120A. Complementary channels 120A, 120B may be of different (complementary) materials, a same material but different crystalline orientation, etc. The operation (e.g., conductivities) of complementary channels 120A, 120B may be aided by strain exerted on channels 120. In some embodiments, complementary strains (e.g., tensile and compressive) are provided to complementary channels 120A, 120B. In embodiments, at least one of a tensile or compressive strain is provided to one of channels 120A, 120B. For example, in some embodiments, a longitudinal compressive stress is exerted on a PMOS channel 120B (e.g., by in-line source and drain bodies 110B, to increase hole mobility). In some embodiments, a longitudinal tensile stress is exerted on an NMOS channel 120A (e.g., by in-line source and drain bodies 110A, to increase electron mobility).

In many embodiments, transverse strain is provided to one or both of channels 120A, 120B, e.g., by structures adjacent and between channels 120A and/or 120B. Either or both of tensile and compressive strains may be provided, for example, by using different, complementary materials between different pairs of channels 120A, 120B. In some embodiments, a transverse tensile strain is provided to one of channels 120A, 120B. In some embodiments, a transverse compressive strain is provided to one of channels 120A, 120B. In many embodiments, transverse strain is provided at or adjacent midpoints of channels 120 by structures adjacent channels 120, e.g., at and between gate structures 125.

Gate stacks or structures 125 are stacks of gate materials, including gate insulators (e.g., gate dielectric layers on channels 120) and gate metals, over channels 120 (e.g., around nanoribbon channels 120). Gate structures 125A, 125B are located at midpoints of channels 120A, 120B, respectively, between source and drain bodies 110A, 110B, respectively. Gate structures 125A, 125B may include corresponding first and second gate electrode materials, e.g., n- and p-type workfunction metals (WFM). For example, transistor structures 101A, 101B may include stacks of nanoribbon channels 120A, 120B, and gate structures 125A, 125B may include n- and p-type WFM, respectively, between the nanoribbon channels 120A, 120B. Gate structures 125A extend in the y-directions, over adjacent stacks of NMOS channels 120A extending in the x-directions, orthogonal to the y-directions of structures 125, and coupled to n-type source and drain bodies 110A. Gate structures 125B extend in the y-directions, over adjacent stacks of PMOS channels 120B extending in the x-directions and coupled to p-type source and drain bodies 110B.

Floating structures 125C are stacks of gate materials over semiconductor structures 122, with structures and materials matching those of structures 125A, 125B (e.g., with metal 126 on insulator 124, and insulator 124 on semiconductor structures 122 extending through structure 125). Unlike gate structures 125A, 125B, structures 125C are between (and not necessarily included in) transistor structures 101A, 100B and not electrically connected (for example, by vias 133) to gate signals. Floating structures 125C are parallel to gate structures 125A, 125B between transistor structures 101.

Gate plugs 151, 152 may provide transverse strain to channels 120 at and between gate structures 125. In many embodiments, plugs 151, 152 provide complementary strains, for example, to complementary channels 120A, 120B. Gate plugs 151, 152 are dielectric structures on (e.g., in contact with) adjacent gate structures 125. First and second gate plugs 151, 152 include opposing first and second sidewalls 155, 156 on adjacent gate structures 125. Some plugs 151 are between gate structures 125A of transistor structures 100A with both first and second sidewalls 155, 156 on gate structures 125A. Some plugs 152 are between gate structures 125B of transistor structures 101B with both first and second sidewalls 155, 156 on gate structures 125B. Other plugs 151, 152 are between gate structures 125A, 125B with a first sidewall 155 on a first gate structure 125A and a second sidewall 156 on a second gate structure 125B.

First and second gate plugs 151, 152 include any suitable materials, such as dielectrics or other electrical insulator materials. Plugs 151, 152 provide electrical isolation and, advantageously, include low-K (i.e., low permittivity) dielectric material(s), e.g., having a relative permittivity less than 5. Multiple dielectric materials may be employed, for example, to provide necessary strain to gate structures 125A and/or 125B while maintaining other characteristic values, e.g., relative permittivity. In many embodiments, plugs 151, 152 have different (e.g., complementary) compositions, for example, to provide complementary strains.

First and second gate plugs 151, 152 are of any suitable size. While larger plugs 151, 152 are able to provide more strain and better electrical isolation (e.g., lower parasitic capacitances between adjacent gate structures 125), dimensions of plugs 151, 152 (e.g., in the x- and y-directions) are often significantly limited by tight area constraints of device 100. Advantageously, plugs 151, 152 are at least as long (e.g., in the x-directions, parallel with channels 120) as a gate length L_{g} of gate structures 125, for example, to have a sufficiently large surface to provide strain and isolation to and between gate structures 125. Advantageously, plugs 151, 152 have a width W (e.g., in the y-directions, between adjacent structures 125) equal to or shorter than a gate length L_{g} of gate structures 125, for example, to satisfy the tight area constraints of device 100. In some embodiments, plugs 151, 152 have a width W equal to or shorter than a one-and-a-half times the gate length L_{g} of gate structures 125, for example, to provide more strain to and between adjacent structures 125. For example, adjacent gate structures 125 may have a gate length L_{g} of 20 nm, and a gate plug 151 or 152 between the structures 125 may have a length (e.g., in the x-direction) of just over 20 nm and a width W (e.g., in the y-direction) of less than 20 nm. In embodiments requiring more strain, a gate plug 151 or 152 between structures 125 having the same dimensions might have the same length of just over 20 nm, but a width W of 25 nm (or longer, but less than 30 nm).

First gate plugs 151 include any suitable materials, such as dielectrics that exert outward (e.g., expansive) forces, towards adjacent gate structures 125, and so provide compressive transverse strain on adjacent channels 120A (e.g., at midpoints of channels 120A, at gate structures 125A). In the exemplary embodiment of FIG. 1A, plugs 151 include silicon and nitrogen, which may provide a compressive strain to (and so increase electron mobility in, and conductivity of) NMOS channels 120A. For example, plugs 151 include silicon and nitrogen at both sidewalls 155, 156. In the exemplary embodiment of FIG. 1A, plug 151 includes silicon and nitrogen throughout plug 151, between sidewalls 155, 156, e.g., at a centerline CL between sidewalls 155, 156. (The centerlines CL (or axes) shown through plugs 151 in FIG. 1A extend in the z-directions through the plan-view, x-y viewing plane.)

In many embodiments, plug 151 includes silicon and nitrogen and lacks significant quantities of other elements, such as oxygen. In many embodiments, plug 151 has an atomic composition of at least 30 percent silicon, at least 30 percent nitrogen, and less than five percent oxygen (for example, no detectable amount of oxygen, e.g., < 1% oxygen). These concentrations of silicon and nitrogen throughout plug 151 may provide sufficient strain to adjacent gate structures 125. In some embodiments, plug 151 has an atomic composition of at least 25 percent silicon, at least 40 percent nitrogen, and less than five percent oxygen (for example, no detectable amount of oxygen, e.g., < 1% oxygen), which may advantageously provide increased strain to structures 125. Plug 151 may be differentiated from other structures (e.g., plug 152) or dielectrics by the absence of other detectable elements, such as carbon. In some embodiments, plug 151 has no detectable amount of carbon, e.g., < 1% carbon. Any suitable material(s) and composition may be deployed.

Gate plugs 151 may be fabricated by any suitable means. In some embodiments, plugs 151 include a liner layer 157 or 158 (for example, that includes sidewalls 155, 156) and a bulk portion within liner layer 157, 158, as illustrated in FIG. 1A. In some such embodiments, layer 157, 158 (and sidewalls 155, 156) of plug 151 includes silicon and nitrogen (etc.) at approximately the same proportions as the bulk portion, for example, within five percent (of the total atomic composition of plug 151). For example, plug 151 may have an atomic composition of at least 25% Si, at least 40% N, and < 1% oxygen at both sidewalls 155, 156, and plug 151 may have a same atomic composition at centerline CL (e.g., of at least 25% Si, at least 40% N, and < 1% O). In some embodiments, plugs 151 are continuous, without any outer layer 157, 158 or at least any apparent interface between an outer nitride layer 157, 158 and inner nitride bulk or fill portion. In many embodiments, as in the exemplary embodiment of FIG. 1A, layers 157, 158 (e.g., on opposing sides of plug 151) are a continuous layer 157 or 158 (e.g., forming a continuous perimeter of plug 151).

Second gate plugs 152 include any suitable materials, such as dielectrics that exert inward (e.g., contractive) forces, between adjacent gate structures 125, and so provide tensile transverse strain on adjacent channels 120B (e.g., at midpoints of channels 120B, at gate structures 125B). Plugs 152 may include distinct portions with different compositions, for example, to optimize the distinct portions for distinct purposes. In many embodiments, plug 152 includes a liner layer 157, 158 (for example, that includes sidewalls 155, 156) of silicon and nitrogen, e.g., as described of layer(s) 157, 158 of plug 151. Layer 157 or 158 may provide an isolation barrier on gate structures 125, while one or more other portions of plug 152 provide strain, etc. In some embodiments, plug 152 includes a liner layer 157, 158 (for example, that includes sidewalls 155, 156) and a dielectric structure 153 surrounded or encircled by layer 157, 158 (e.g., between sidewalls 155, 156), as illustrated in FIG. 1A. In some embodiments, plug 152 includes layer 157, 158 (for example, that includes sidewalls 155, 156) and a void or cavity surrounded or encircled by layer 157, 158 (e.g., between sidewalls 155, 156). The void or cavity may be a space between layers 157, 158 and sidewalls 155, 156 and may serve as a buffer and minimize the transmission of any strain between channels 120B exerted from gate plugs 151 adjacent channels 120A.

A composition of dielectric structure 153 (e.g., an inner, bulk portion of plug 152) may be optimized for providing strain to, and electrical isolation between, gate structures 125. In the exemplary embodiment of FIG. 1A, dielectric structure 153 includes only silicon and oxygen and, notably, no detectable amount of nitrogen. In some embodiments, dielectric structure 153 has an atomic composition of at least thirty percent silicon, at least thirty percent oxygen, and less than five percent nitrogen, which may optimize a balance of strain and low-K isolation. In some embodiments, structure 153 has an atomic composition of at least thirty percent silicon, at least fifty percent oxygen, and no detectable amount of nitrogen (e.g., less than 1% nitrogen), which may provide an advantageously low permittivity. In some embodiments, structure 153 has an atomic composition of at least forty percent silicon, at least forty percent oxygen, and less than 5% nitrogen, which may provide a sufficiently low permittivity at a reduced cost (e.g., of time and/or money). Any suitable material(s) may be deployed.

Outer layer 157, 158 of plug 152 may provide electrical isolation, as well as other isolation, such as a hermetic barrier between structures 125, 153. In many embodiments, as in the exemplary embodiment of FIG. 1A, layers 157, 158 (e.g., on opposing sides of plug 152) are a continuous layer 157 or 158 (e.g., forming a continuous perimeter of plug 152, around dielectric structure 153). In some embodiments, layer(s) 157, 158 of plug 152 have a same atomic composition as described of layer(s) 157, 158 of plug 151, for example, of at least 25 percent silicon, at least 40 percent nitrogen, and < 1% oxygen. In some embodiments, layer(s) 157, 158 of plugs 151 and 152 are deposited concurrently.

Layers 157, 158 may be of any suitable thickness, for example, of sufficient impermeability to serve as a barrier (e.g., between structures 125, 153, to reactive oxygen species or other potentially damaging substances). For a given space or plug 152, e.g., a device pitch for adjacent transistor structures 101, a thickness of layer(s) 157, 158 may interact with a dimension of isolation plug 152. A minimal thickness of layer(s) 157, 158 may advantageously provide more space for a strain-exerting and/or low-K dielectric structure 153 between adjacent gate structures 125. In some embodiments, layer 157 or 158 has a thickness of approximately 2 nm. Risk of damage from exposure to oxygen, etc., may be most acute during deposition, for example, at elevated temperatures or other conditions of increased reactivity. As such, various deposition methods may compel various thicknesses (or compositions) of layer(s) 157, 158. In some embodiments, layer 157 or 158 has a thickness of 3 nm or more, e.g., to protect against oxidation, etc., of gate metals of gate structures 125 during deposition of a material of dielectric structure 153.

Although gate plugs 152 in the exemplary embodiment of FIG. 1A include dielectric structures 153 (e.g., of silicon and oxygen), in some embodiments, plugs 152 instead include a void or cavity surrounded or encircled by layer 157, 158, e.g., between sidewalls 155, 156 and at centerline CL. Layer(s) 157, 158 may contain vacuum or air (e.g., gas, including nitrogen and/or oxygen) in the void or cavity. The void or cavity may act as a buffer and minimize the transmission of any strain by gate plugs 151 between or towards channels 120B.

The y-z viewing planes B-B', D-D', and F-F' of FIGS. 1B, 1D, and 1F, respectively, are each through channels 120A, 120B (transversely), gate structures 125A, 125B (longitudinally), and gate plugs 151, 152, as shown in FIG. 1A. The plan view of FIG. 1A illustrates each of planes B-B', D-D', and F-F' extending in the y-directions, longitudinally through first and second gate structures 125A and third and fourth gate structures 125B. Gate structures 125A, 125B are over channels 120A, 120B, respectively, which extend in the x-directions coupled to n- and p-type source and drain bodies 110A, 110B, respectively. As described, channels 120 may include any suitable structure(s), such as stacks of channel material layers. First gate plug 151 has opposing first and second sidewalls 155, 156 with first sidewall 155 on a first gate structure 125A and second sidewall 156 on a second gate structure 125A. In the exemplary embodiment of FIG. 1A, plugs 151 include silicon and nitrogen at sidewalls 155, 156 and centerline CL. Second gate plug 152 has opposing third and fourth sidewalls 155, 156 with third sidewall 155 on a third gate structure 125B and fourth sidewall 156 on a fourth gate structure 125B. In the exemplary embodiment of FIG. 1A, plugs 152 include silicon and nitrogen at sidewalls 155, 156. In the exemplary embodiment of FIG. 1A, plugs 152 include silicon and oxygen at centerline CL in dielectric structure 153. In some embodiments, as described further below (e.g., at least at FIGS. 1D and 1F), plugs 152 include a void or cavity between sidewalls 155, 156.

Planes B-B', D-D', and F-F' are through either a gate plug 151 or 152 between second and third gate structures 125A, 125B with fifth sidewall 155 on second gate structure 125A and sixth sidewall 156 on third gate structure 125B. Planes B-B' and F-F' are through other gate plugs 152 (e.g., having silicon and nitrogen at sidewalls 155, 156 and dielectric structure 153 therebetween, at centerline CL, for example, having a dielectric including silicon and oxygen). Plane D-D' is through another gate plug 151 (e.g., having silicon and nitrogen at sidewalls 155, 156 and at centerline CL therebetween).

Some embodiments include structures 125C over semiconductor structures 122, between transistor structures 101. The y-z viewing planes C-C' and E-E' of FIGS. 1C and 1E, respectively, are each through semiconductor structures 122A, 122B (transversely) and structures 125C (longitudinally), and plugs 151, 152, as shown in FIG. 1A. Plane C-C' is through plugs 151, 152 (between structures 122A, 122B, respectively), while no plugs 151, 152 are on plane E-E'. Structures 125C may have constituent portions (and include materials) similar to or the same as gate structures 125A and/or 125B, but (unlike gate structures 125A, 125B) structures 125C are not coupled to an interconnect network by any vias 133. Structures 125C do not control conduction through semiconductor structures 122.

In some embodiments, as in the example of FIG. 1A, channels 120A, 120B include complementary channel materials. The channel materials are referred to herein as "complementary" because one channel material is advantageous for an NMOS transistor structure 101 while the other channel material is advantageous for a PMOS transistor structure 101. In exemplary embodiments, channel material within an NMOS structure 101 offers higher electron mobility than the channel material within a PMOS structure 101. In exemplary embodiments, channel material within a PMOS transistor structure 101 likewise offers higher hole mobility than the channel material within a NMOS transistor structure 101. The high complementary carrier mobilities may therefore enable high drive currents independently for both NMOS and PMOS structures 101.

In accordance with some embodiments, NMOS and PMOS channels 120A, 120B have complementary chemical compositions (e.g., compound compositions) where one composition is advantageous for an n-type transistor and the other composition is advantageous for a p-type transistor. For example, channels 120A may each be a first Group IV, Group III-V, metal oxide, or metal chalcogenide semiconductor material while channels 120B are each a second Group IV, Group III-V, metal oxide, or metal chalcogenide semiconductor material. In some embodiments, one of first and second channels 120A, 120B includes a semiconductor element absent from the other of first and second channels 120A, 120B. In some notable Group IV embodiments, PMOS channels 120B include germanium (e.g., Si_{1-X}Ge_{X}, Ge_{1-X}Sn_{X}, or substantially pure Ge) while NMOS channels 120A include primarily silicon and may be substantially (pure) silicon (e.g., with germanium absent in channels 120A).

In some alternative Group III-V embodiments, channels 120B include a III-V material offering higher hole mobility, or may include a Group IV material (e.g., substantially pure Ge) having higher hole mobility. For such embodiments, channels 120A may further include another III-V material offering higher electron mobility, such as InGaAs, or InAs, for example. In other embodiments, channels 120A, 120B include a transition metal and a chalcogen. The chalcogen may be sulfur, selenium, and tellurium (e.g., MS_{X}, MSe_{X}, or MTe_{X}). The transition metal may be any transition metal such as any element of groups 4 through 11, the group 3 elements scandium and yttrium, and the inner transition metals (e.g., f-block lanthanide and actinide series). Advantageous transition metals for channels 120A within NMOS structure 100A include molybdenum and tungsten while advantageous transition metals for channels 120B within PMOS structure 100B include copper and indium. In still other embodiments, channels 120A include one or more first metals and oxygen (i.e., first metal oxide semiconductor), such as indium gallium zinc oxide (e.g., InGaZnO or simply "IGZO") while channels 120B include one or more second metals and oxygen (i.e., a second metal oxide semiconductor), such as CuO_{X}.

In accordance with some embodiments, NMOS and PMOS channels 120A, 120B have complementary crystallinity where one crystal structure and/or crystal orientation is advantageous for NMOS channels 120A and the other crystal structure and/or crystal orientation is advantageous for PMOS channels 120B. In some embodiments where channels 120A, 120B are both crystalline (e.g., substantially monocrystalline), NMOS channels 120A have cubic crystalline of a first crystallographic orientation advantageous for an n-type transistor structure 101 while the crystallinity of PMOS channels 120B is also cubic, but with second crystallographic orientation advantageous for a p-type transistor structure 101. For example, channels 120A may have a (100) crystallographic orientation (i.e., <100> coincident with z-axis in FIG. 1A) for maximum electron mobility within the (e.g., x-y) plane of channel channels 120A. In such embodiments, channels 120B may instead have a (110) crystallographic orientation (i.e., <110> coincident with z-axis in FIG. 1) for maximum hole mobility within the (e.g., x-y) plane of channels 120B. In embodiments where crystallinity of channel material is complementary between transistor structures 101A, 100B, the channel materials may be either of substantially the same chemical composition (e.g., both channels 120A, 120B being substantially pure silicon) or of different chemical compositions (e.g., channels 120A may be pure silicon while channels 120B may be a silicon germanium alloy, germanium, or another composition). Hence, crystallinity may be the only significant variation between complementary channel materials, or may augment a difference in chemical composition between complementary channel materials.

Complementary channels 120A, 120B may be of any suitable material(s) or structure(s). In some embodiments, channels 120A, 120B of complementary conductivity type may be of same materials, same crystalline orientation, etc., but coupled to source and drain bodies 110A, 110B of complementary conductivity type (e.g., having complementary n- and p-type dopants). As described, n-type source and drain bodies 110A and p-type source and drain bodies 110B are under contact structures 131, 132 (obscured by structures 131, 132 in FIG. 1A, but further described at least at FIG. 1G).

FIGS. 1B illustrates IC device 100 at cross-sectional viewing plane B-B' through channels 120A, 120B, gate structures 125A, 125B, and gate plugs 151, 152, e.g., as described at FIG. 1A. In the exemplary embodiment of FIG. 1B, channels 120 are nanoribbon channels 120A, 120B. Device 100 includes multiple NMOS GAAFET structures 100A (each with a gate structure 125A over a stack 121 of n-type channels 120A) and multiple pMOS GAAFET structures 100B (each with a gate structure 125B over a stack 121 of p-type channels 120B). Gate plug 151 is on and between gate structures 125A and FET structures 101A. One gate plug 152 is on and between gate structures 125B (and FET structures 101B), and another gate plug 152 is on and between gate structures 125A, 125B (and FET structures 101A, 101B).

Channels 120 (in stacks 121) extend through gate structures 125 in the x-directions (and, for example, couple source and drain bodies 110 in front of and behind the y-z viewing plane). Gate structures 125 are over trench isolations 194 on substrate 199 (e.g., shallow trench isolations (STI) 194 adjacent subfins of substrate 199), and isolations 134, 135 are adjacent structures 125, over and on sidewalls of structures 125. Vias 133 couple gate structures 125 through isolations 134. A dielectric layer 195 (such as an etch-stop layer 195) is on a backside of substrate 199. Gate plugs 151, 152 are through a semiconductor material and on layer 195, between semiconductor structures 122.

Gate structure 125 may include one or more dielectric (or other) materials in a gate insulator 124 on or over channels 120 and one or more electrode materials in a gate metal 126 on or over insulator 124. In many embodiments, gate structures 125A, 125B include distinct first and second gate metals 126A, 126B between nanoribbon channels 120A, 120B, for example, n-and p-type WFM 126A, 126B advantageous for NMOS and PMOS structures 101A, 100B, respectively. In some embodiments, transistor structures 101A, 100B share a common gate structure 125. Gate structure 125 and gate metal 126 may include one or more electrode materials in a stack of layers, for example, of gate metals between gate insulator 124 (on channel 120) and a contact or via 133. In many embodiments, transistor structures 101A, 100B (both with shared and unshared structures 125) include a same bulk or fill metal 126 throughout most of gate structures 125A, 125B and include n- and p-type WFM 126A, 126B adjacent insulator 124 and channels 120A, 120B.

In some embodiments, gate structure 125A includes a first high-K (i.e., "high-permittivity") dielectric or ferroelectric material in insulator 124 advantageous for n-type transistor structures 100A and a first WFM 126A advantageous for n-type transistor structures 100B while gate structure 125B includes a second high-K dielectric or ferroelectric material in insulator 124 advantageous for p-type transistor structures 101B and a second WFM 126B advantageous for p-type transistor structures 100B. In some embodiments, gate structures 125A, 125B include gate insulators 124 with one or more (e.g., different) dipole dopants in one or both of structures 125A, 125B. In many embodiments, gate insulators 124 include multiple layers of dielectric (and/or ferroelectric, etc.) materials, for example, a high-K dielectric layer over a passivation layer of a native oxide on channel 120.

Exemplary high-K dielectrics (e.g., in gate insulator 124) include metal oxides (e.g., including one or more of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate), or metal silicates (e.g., including one or more of above metals, oxygen and silicon). Examples of WFM 126 (e.g., in gate structure 125) include ruthenium, palladium, platinum, cobalt, nickel, and conductive metal oxides (e.g., ruthenium oxide), hafnium, zirconium, titanium, tantalum, aluminum, alloys of these metals, and carbides of these metals such as hafnium carbide, zirconium carbide, titanium carbide, tantalum carbide, and aluminum carbide.

Gate plug 151 includes opposing first and second sidewalls 155, 156. Sidewall 155 of first gate plug 151 is on a first gate structure 125A over a first stack 121 of n-type nanoribbon channels 120A. Sidewall 156 of first gate plug 151 is on a second gate structure 125A over a second stack 121 of n-type nanoribbon channels 120A. Plug 151 may be formed from a front or back side of substrate 199, and layer(s) 157, 158 (if apparent) may indicate a method of fabrication. For example, in the exemplary embodiment of FIG. 1B, a filling of plug 151 from a front side may be suggested by the location of layer 157 under, and including sidewalls 155, 156 of, plug 151.

Gate plug 152 (between gate structures 125B) includes opposing third and fourth sidewalls 155, 156. Sidewall 155 of gate plug 152 is on a third gate structure 125B over a third stack 121 of p-type nanoribbon channels 120B. Sidewall 156 of gate plug 152 is on a fourth gate structure 125B over a fourth stack 121 of p-type nanoribbon channels 120B. Gate plug 152 (between gate structures 125B) includes dielectric structure 153 between layer(s) 157 or 158 (and sidewalls 155, 156). In some embodiments, as is described at least at FIG. 1D, plug 152 includes a void or cavity between layer(s) 157 or 158 (and sidewalls 155, 156). Plug 152 may be formed from a front or back side of substrate 199, and layer(s) 157, 158 may indicate a method of fabrication. For example, in the exemplary embodiment of FIG. 1B, a filling of plug 152 with dielectric structure 153 from a back side may be suggested by the location of layer 157 over structure 153 and including sidewalls 155, 156 of plug 152. In some embodiments, layer(s) 157, 158 of plugs 151 and/or 152 are not over or under plugs 151 and/or 152, for example, after a planarization operation on a front and/or back side of substrate 199.

Another gate plug 152 (located centrally, between other plugs 151, 152 and gate structures 125A, 125B and transistor structures 101A, 101B) includes opposing fifth and sixth sidewalls 155, 156. Sidewall 155 of central plug 152 is on a second gate structure 125A over second stack 121 of n-type nanoribbon channels 120A. Sidewall 156 of central plug 152 is on third gate structure 125B over third stack 121 of p-type nanoribbon channels 120B. The additional (e.g., central) gate plug 152 (between gate structures 125A, 125B) includes dielectric structure 153 between layer(s) 157 or 158 (and sidewalls 155, 156).

Substrate 199 may include any suitable material or materials. Any suitable semiconductor or other material can be used. Substrate 199 may be any suitable structure, such as a wafer, die, etc. Substrate 199 may include a semiconductor material that transistors can be formed out of and on, including a crystalline material, such as monocrystalline or polycrystalline silicon, germanium, silicon germanium, a III-V alloy material (e.g., gallium arsenide), a silicon carbide, a sapphire (e.g., Al₂O₃), or any combination thereof. In some embodiments, substrate 199 includes crystalline silicon and subsequent components are also silicon. Substrate 199 may be a silicon-on-insulator (SOI) substrate. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base. In some embodiments, a crystalline material of substrate 199 (e.g., an insulator or semiconductor material, such as silicon, etc.) is removed (e.g., by grinding) from a back side of substrate 199. In some such embodiments, further build-up layers (such as interconnect layers) may be formed on the back side of substrate 199. For example, subfins under channels 120 may be removed, and gate structures 125 (or other portions of transistor structures 101) may be coupled to a back-side interconnect layer. Substrate 199 may include semiconductor materials, metals, dielectrics, dopants, and other materials commonly found in IC substrates.

FIGS. 1C shows device 100 at cross-sectional viewing plane C-C' through semiconductor structures 122, floating structures 125C, and gate plugs 151, 152, e.g., as described at FIG. 1A. Gate plug 151 is between semiconductor structures 122A, and plug 152 is between semiconductor structures 122B. In the exemplary embodiment of FIG. 1C, semiconductor structures 122 include stacks 121 of nanoribbons (and subfins beneath stacks 121) between transistor structures 101. No gate vias couple floating structure 125C.

Plugs 151, 152 may be formed from a front or back side of substrate 199, and layer(s) 157, 158 may indicate a method of fabrication. In the exemplary embodiment of FIG. 1C, a filling of plug 152 with dielectric structure 153 from a front side may be suggested by the location of layer 158 under structure 153 and including sidewalls 155, 156 of plug 152. In many embodiments, all of plugs 152 in device 100 are formed from a same (e.g., front or back) side of substrate 199.

FIGS. 1D illustrates IC device 100 at cross-sectional viewing plane D-D' through channels 120A, 120B, gate structures 125A, 125B, and gate plugs 151, 152, e.g., as described at FIG. 1A. Gate plug 152 is on and between gate structures 125B and FET structures 100B. One gate plug 151 is on and between gate structures 125A (and FET structures 101A), and another gate plug 151 (e.g., centrally located) is on and between gate structures 125A, 125B (and FET structures 101A, 101B).

Notably, plug 152 between gate structures 125B and transistor structures 100B includes a void or cavity 154 at centerline CL, between layer(s) 157 and/or 158 (and sidewalls 155, 156). Cavity 154 is a space or gap surrounded or encircled by layer(s) 157 and/or 158 (for example, with layer(s) 157, 158 containing vacuum or air (e.g., gas, including nitrogen and/or oxygen) in void or cavity 154 of plug 152). In many embodiments, all of plugs 152 in device 100 are formed with a same core (e.g., same material on centerline CL), for example, plugs 152 all with either a dielectric structure 153 or cavity 154 between sidewalls 155, 156.

Plug 152 may be formed from a front or back side of substrate 199, and layer(s) 157, 158 (and seam 159 between layer(s) 157 and/or 158) may indicate a method of fabrication. In the exemplary embodiment of FIG. 1D, a forming of cavity 154 within plug 152 from a front side may be suggested by the location of seam 159 at a joining of layer(s) 157 and/or 158 over cavity 154, at an upper or front side of plug 152.

FIGS. 1E shows device 100 at cross-sectional viewing plane E-E' through semiconductor structures 122 and an uninterrupted floating structure 125C, e.g., as described at FIG. 1A. No gate plugs 151, 152 are on structure 125C or between semiconductor structures 122. No gate vias couple floating structure 125C. In the exemplary embodiment of FIG. 1C, semiconductor structures 122 include stacks 121 of nanoribbons (and subfins beneath stacks 121) between transistor structures 101 (e.g., continuous with semiconductor structures 122 and channels 120 of FIGS. 1B-1D and 1F).

FIGS. 1F illustrates device 100 at cross-sectional viewing plane F-F' through channels 120A, 120B, gate structures 125A, 125B, and gate plugs 151, 152, e.g., as described at FIG. 1A. In the exemplary embodiment of FIG. 1F, channels 120 are nanoribbon channels 120A, 120B (e.g., continuous with semiconductor structures 122 and channels 120 of FIGS. 1B-1E). Device 100 includes multiple NMOS GAAFET structures 100A (each with a gate structure 125A over a stack 121 of n-type channels 120A) and multiple pMOS GAAFET structures 100B (each with a gate structure 125B over a stack 121 of p-type channels 120B). Gate plug 151 is on and between gate structures 125A and FET structures 101A. One gate plug 152 (with cavity 154) is on and between gate structures 125B (and FET structures 101B), and another gate plug 152 (with dielectric structure 153) is on and between gate structures 125A, 125B (and FET structures 101A, 101B).

Plugs 151, 152 may be formed from a front or back side of substrate 199, and layer(s) 157, 158 may indicate a method of fabrication. In the exemplary embodiment of FIG. 1F, a filling of plug 152 between gate structures 125A, 125B with dielectric structure 153 from a back side may be suggested by the location of layer 157 over structure 153 and including sidewalls 155, 156 of plug 152.

Notably, plug 152 between gate structures 125B and transistor structures 100B includes cavity 154 at centerline CL, containing vacuum or air (e.g., gas, including nitrogen and/or oxygen) between layer(s) 157 and/or 158 (and sidewalls 155, 156). In many embodiments, all of plugs 152 in device 100 are formed with a same core (e.g., same material on centerline CL), for example, plugs 152 all with either a dielectric structure 153 or cavity 154 between sidewalls 155, 156.

Plug 152 may be formed from a front or back side of substrate 199, and layer(s) 157, 158 (and seam 159 between layer(s) 157 and/or 158) may indicate a method of fabrication. In the exemplary embodiment of FIG. 1F, a forming of cavity 154 within plug 152 from a back side may be suggested by the location of seam 159 at a joining of layer(s) 157 and/or 158 under cavity 154, at a lower or back side of plug 152.

FIGS. 1B-1F show various alternative embodiments, e.g., for illustrative purposes, of IC device 100 with dielectric plugs 151, 152 on and between structures 125. Other embodiments are possible. For example, any of plugs 152 shown in FIG. 1A (e.g., between p-type gate structures 125B or between n- and p-type gate structures 125A, 125B) may include a dielectric structure 153 between sidewalls 155, 156 or a cavity 154 between sidewalls 155, 156. In many embodiments, all plugs 152 in device 100 will have a same or similar structure (e.g., either a dielectric structure 153 or cavity 154 between sidewalls 155, 156). Any of plugs 151, 152 may be fabricated in any suitable fashion, for example, from a front or back side of substrate 199.

FIGS. 1G illustrates device 100 at either of multiple possible cross-sectional viewing planes G-G' through source and drain bodies 110, nanoribbon channels 120, and gate structure 125. In FIG. 1G, nanoribbon channels 120 extend in the x-directions (through gate structure 125) and couple to source and drain bodies 110. Channels 120 in FIG. 1G are all channels 120A or 120B, and both of source and drain bodies 110 are correspondingly n-type bodies 110A or p-type bodies 110B. One of source and drain bodies 110 is a source body 110, and the other of source and drain bodies 110 is a drain body 110. Bodies 110 may include or contact interface layers 113 on contact structures 131, 132. Layers 113 may be alloyed layers 113 (e.g., a silicide layer 113), for example, including a semiconductor material of body 110 and a metal. Each of source and drain bodies 110 is coupled by a contact structure 131 or 132 to an interconnect network through contact vias 133. One such via 133 is on viewing plane G-G', visible in FIG. 1G on contact structure 132, and another via is off-plane (e.g., in the negative y-dimension, as shown in FIG. 1A).

Between bodies 110, gate structure 125 is also coupled off-plane (e.g., in the positive y-dimension, as shown in FIG. 1A) to an interconnect network by a via 133 (e.g., through isolation 134). Gate structure 125 includes gate insulator 124 on or over channels 120 and one or more gate metals 126 (e.g., in a stack of layers) on or over insulator 124. One or more gate metals 126 may be WFM 126A or 126B, particular to a gate structure 125A or 125B, but gate structures 125 may include one or more metals 126 with no, negligible, or minimal workfunction effect, for example, used in either or both gate structures 125A, 125B.

Viewing plane G-G' may be through source and drain bodies 110A, and FIG. 1G may show an NMOS transistor structure 101A, e.g., having different materials than a PMOS transistor structure 100B. For example, an NMOS transistor structure 101A includes a gate WFM 126A in a gate structure 125A over NMOS channels 120A coupled to, and in contact with, n-type source and drain bodies 110A. Source and drain bodies 110A may have any chemical composition and microstructure suitable for an NMOS transistor. Bodies 110A may include monocrystalline or polycrystalline semiconductor material. In many embodiments, n-type source and drain bodies 110A include a Group IV or III-V semiconductor material doped with any impurity dopants known to be suitable for the desired conductivity type, and to any concentration known to be suitable for transistors. In some embodiments, bodies 110A include silicon and an n-type dopant, such as phosphorous, arsenic, or another donor impurity.

Viewing plane G-G' may be through source and drain bodies 110B, and FIG. 1G may show a PMOS transistor structure 100B, e.g., having different materials than an NMOS transistor structure 101A. For example, a PMOS transistor structure 100B includes a gate WFM 126B in a gate structure 125B over PMOS channels 120B coupled to, and in contact with, p-type source and drain bodies 110B. Bodies 110B may have any chemical composition and microstructure suitable for a PMOS transistor. Source and drain bodies 110B may include monocrystalline or polycrystalline semiconductor material. In many embodiments, source and drain bodies 110B include a Group IV or III-V semiconductor material doped with any impurity dopants known to be suitable for the desired conductivity type, and to any concentration known to be suitable for transistors. In some embodiments, bodies 110B include silicon, germanium, and a p-type dopant, such as boron, aluminum, gallium or any other acceptor impurity. In some exemplary embodiments, source and drain bodies 110A are predominantly silicon doped with any suitable concentration of donor impurities while source and drain bodies 110B are predominantly silicon germanium doped with any suitable concentration of acceptor impurities.

Gate length L_{g} of gate structure 125 is defined as the longitudinal dimension of channel 120 (e.g., in the x-directions, as described at FIG. 1A) covered by gate metal 126 and insulator 124 of gate structure 125, for example, between pairs of gate spacers 141 or pairs of gate spacers 142.

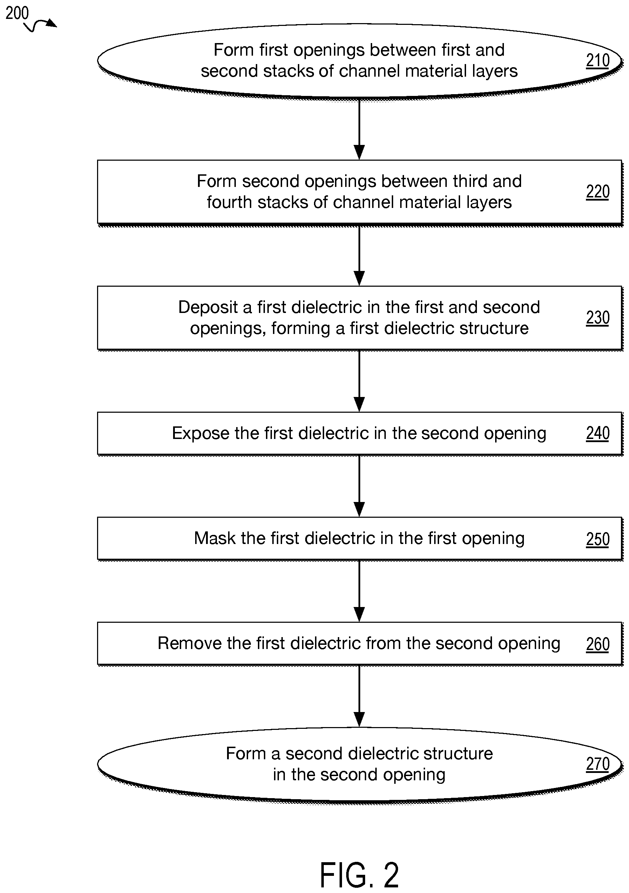

FIG. 2 is a flow chart of methods 200 for forming dielectric gate-cut plugs that may provide complementary strains to adjacent transistor channels, in accordance with some embodiments. Methods 200 include operations 210-270. Some operations shown in FIG. 2 are optional. Additional operations may be included. FIG. 2 shows an example sequence, but the operations can be done in other orders as well, and some operations may be omitted. Some operations can also be performed multiple times before other operations are performed. For example, multiple openings (e.g., gate-cut etches) may be formed between stacks of channel material layers before and any dielectric is deposited in an opening. Some operations may be included within other operations so that the number of operations illustrated FIG. 2 is not a limitation of the methods 200.

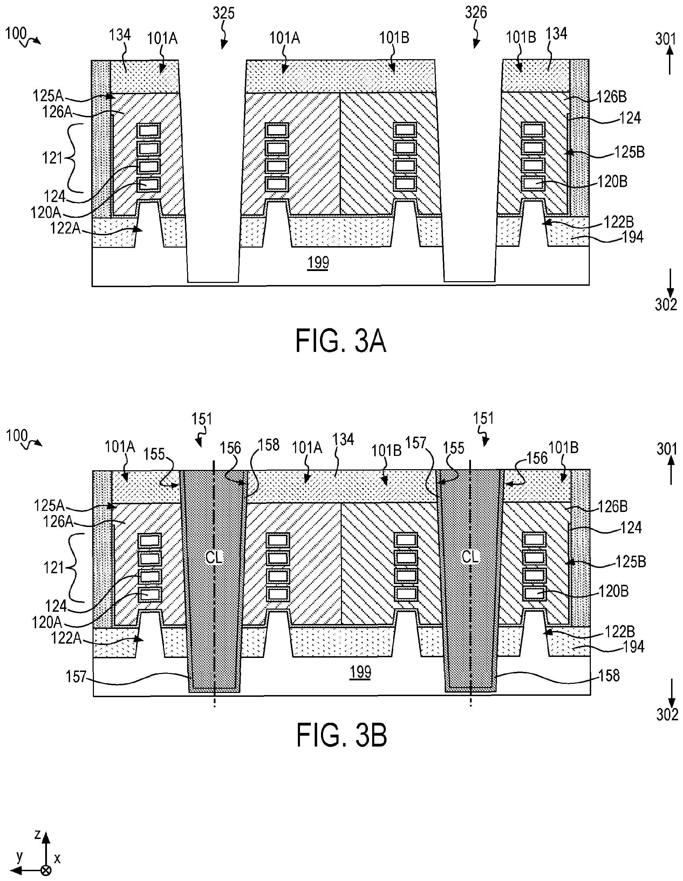

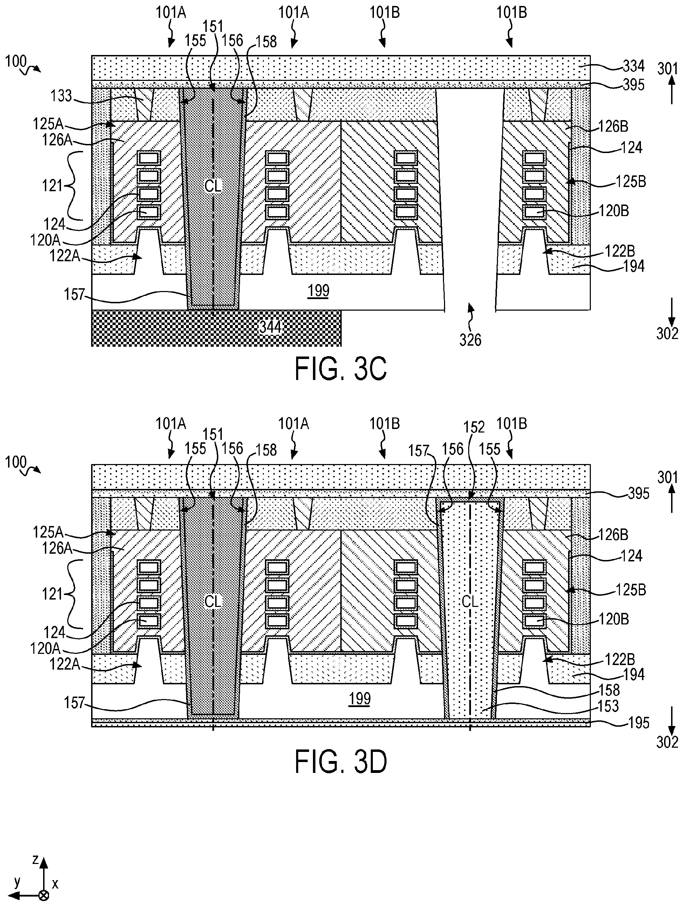

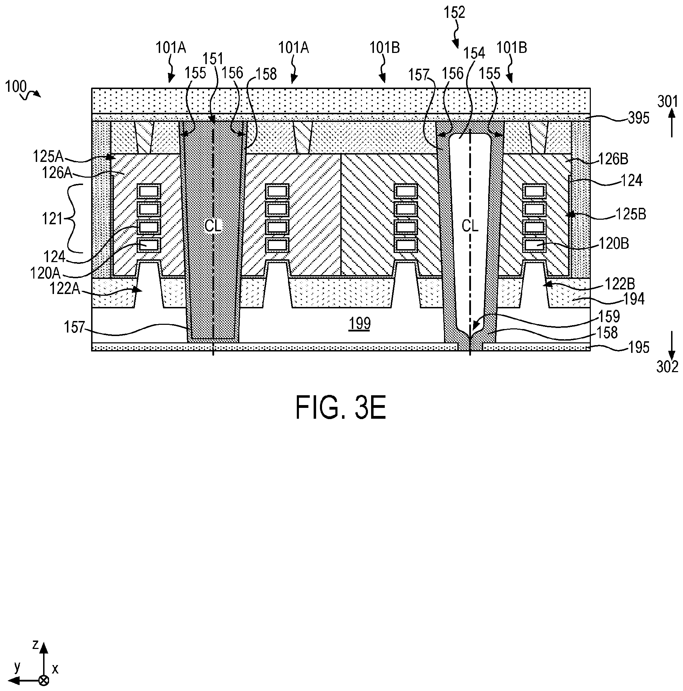

FIGS. 3A, 3B, 3C, 3D, and 3E illustrate cross-sectional profile views of an IC device 100 having complementary gate plugs 151, 152 between gate structures 125A, 125B, at various stages of manufacture, in accordance with some embodiments. FIGS. 3A-3E show possible examples of intermediate structures during an embodiment of a practice of methods 200 of FIG. 2.

Returning to FIG. 2, methods 200 begin at operation 210 with forming a first opening in a first gate stack. In many embodiments, the first opening is between first and second stacks of channel material layers. The first opening may be formed by any suitable means, for example, by etching the opening through a shared gate stack over multiple stacks of channel material layers. In many embodiments, the first opening is etched from a first (e.g., front) side of a substrate, which may be convenient while transistor devices in a device layer are still accessible and still being formed.

The opening may separate the shared, first gate stack into at least two gate stacks. A gate stack may be a gate structure having a stack of gate materials (including one or more gate electrode materials, such as gate metals, on one or more gate insulators, such as a high-K dielectric) over a channel material layer. The opening will form gate sidewalls and will be filled by an isolation (e.g., dielectric) structure to separate adjacent gate structures. Well-controlled etches (such as an atomic layer etch (ALE)) may be employed as necessary to form the opening, e.g., to carefully etch gate sidewalls with desired profiles (such as substantially vertical profiles) or with well-resolved and repeatable critical dimensions (CDs). Such well-controlled etches may take more processing time and other etches may be used for other, less tightly constrained gate cuts. One or more etches (e.g., a directional plasma etch) may be used with various chemistries, temperatures, powers (e.g., radio frequency (RF) power), durations, etc., to achieve desired gate cut profiles given processing constraints (e.g., time and monetary costs).

The channel material layers may be any suitable layers (e.g., thin layers of semiconductor material, such as silicon, germanium, silicon germanium, etc.). The channel material layers may be of any suitable size (such as widths suitable for transistor channels of nanowires, nanoribbons, nanosheets, etc.). In many embodiments, the first and second stacks of channel material layers are of first channel material layers of a first conductivity type, such as n-type. The stacks of channel material layers may be over a shared substrate. For example, in many embodiments, the channel material layers are nanoribbons (or nanowires or nanosheets) in the first and second (and other) stacks of channel material layers, and the nanoribbons (etc.) are over fins and a substrate of a same material (as the channel material).

Methods 200 continue at operation 220 by forming a second opening in a second gate stack over the substrate. In many embodiments, the second opening is between third and fourth stacks of channel material layers. In many embodiments, the third and fourth stacks of channel material layers are of second channel material layers of a second, complementary conductivity type, such as p-type. In some embodiments, first and second channel material layers of complementary conductivity types are similar, e.g., substantially the same, but for the source and drain bodies the channel material layers are coupled between. In many embodiments, the first and second gate stacks are on a shared axis. In some such embodiments, the first and second gate stacks are parts of a single gate stack before the first and second gate stacks are separated, for example, by an etch forming an opening between the first and second gate stacks.

The second opening may be formed by any suitable means. In many embodiments, the second opening is formed by the same means as the first opening. In many embodiments, the second opening is formed from the first side of the substrate. In many embodiments, the second opening is formed concurrently with forming the first opening (e.g., between first and second stacks of channel material layers) and/or an opening between the first and second gate stacks (e.g., between first and second and third and fourth stacks of channel material layers). In many embodiments, multiple first openings are formed between stacks of first channel material layers of a first conductivity type (such as n-type), and multiple second openings are formed between stacks of second channel material layers of a second conductivity type (such as p-type). Many openings may be formed (e.g., concurrently) through many gate stacks (and separating even more gate stacks).

FIG. 3A shows first and second openings 325, 326 between and through gate structures 125 in a workpiece or device 100, in accordance with some embodiments, for example, following performance of operations 210 and 220. Transistor structures 125 include stacks 121 of nanoribbon channels 120 in semiconductor structures 122. Gate structures 125A, 125B include gate insulator 124 on channels 120A, 120B and gate metals 126A, 126B on insulator 124. Gate metals 126A, 126B may each include multiple metals, for example, separate WFM 126A, 126B adjacent channels 120A, 120B and a shared gate metal 126 in both of gate structures 125A, 125B. First opening 325 is between stacks 121 of nanoribbon channels 120A, and second opening 326 is between stacks 121 of nanoribbon channels 120B.

Openings 325 are through isolation 134, gate structures 125, and isolation 194, and into substrate 199 between semiconductor structures 122. In the exemplary embodiment of FIG. 3A, openings 325 are into substrate 199 and between semiconductor structures 122 from a front side 301 of substrate 199, but other embodiments are possible. Gate vias (not shown) may be off (e.g., in front of or behind) the viewing plane or may not yet be formed through isolation 134 over gate structures 125.

Returning to FIG. 2, methods 200 continue at operation 230 with depositing a first dielectric in the first and second openings. The depositing the first dielectric may form dielectric structures in the openings (e.g., a first dielectric structure (i.e., gate plug) of the first dielectric in the first opening). One or more of the dielectric structures (e.g., the first dielectric deposited in the second opening) may be a sacrificial structure.

The first dielectric may be deposited by any suitable means. In some embodiments, the first dielectric is deposited conformally as a liner layer in and over one or both of the first and second openings. In some embodiments, the first dielectric is deposited into and fills one or both of the first and second openings. In some embodiments, the first dielectric is deposited conformally as a liner layer in and over at least one of the first and second openings, and the first dielectric is then deposited into and fills the first opening (e.g., over the conformal, liner layer). In many embodiments, the first dielectric is deposited into and over the first and/or second openings, and excess portions of the first dielectric are removed, for example, by a chemical-mechanical planarization (CMP).

In many embodiments, the first dielectric is deposited from a first (e.g., front) side of the substrate. In some such embodiments, the first dielectric is deposited conformally as a liner layer from the first side, in and over one or both of the first and second openings. In some such embodiments, the first dielectric is deposited into and fills the first opening (e.g., over the conformal, liner layer) from a second (e.g., back) side of the substrate, opposite the first side.

In many embodiments, the first dielectric includes silicon and nitrogen. In many embodiments, depositing the first dielectric in the first and second openings from the first side of the substrate deposits the first dielectric with an atomic composition as described of plug 151 and/or layers 157, 158 at FIG. 1A (for example, at least 25% silicon, at least 40% nitrogen, and less than 5% oxygen, e.g., < 1% oxygen).

The first dielectric structure may be formed to any suitable size. As described of plug 151 at FIG. 1A, the first dielectric structure is advantageously wide enough (e.g., in a dimension separating adjacent gate stacks) to provide sufficient strain and isolation, but small enough to meet device layout (e.g., area) constraints, for example, with a width shorter than a gate length.

FIG. 3B illustrates gate plugs 151 between gate structures 125 in workpiece or device 100, in accordance with some embodiments, for example, following performance of operation 230. Plugs 151 include layers 157, 158 (including sidewalls 155, 156) of the first dielectric on gate structures 125, between semiconductor structures 122 on front side 301 of substrate 199 in the embodiment(s) of FIG. 3B. Front side 301 of substrate 199 (e.g., including plugs 151) is planarized. Layers 157, 158 may be not be apparent, e.g., distinct from the rest of plugs 151, in all embodiments. In the embodiment of FIG. 3B, plugs 151 have same compositions at layers 157, 158 (and sidewalls 155, 156) as in the bulk of the first dielectric, e.g., at centerlines CL.

Returning to FIG. 2, methods 200 continue by exposing the first dielectric in the second opening at operation 240. In some embodiments, the first dielectric in the first opening is exposed concurrently with exposing the first dielectric in the second opening. In many embodiments, the first dielectric in the first and second openings is covered or masked over, for example, by build-up layers on a first substrate side, by semiconductor material on a second (e.g., opposing) side, etc. In some such embodiments, the first dielectric in the second opening is exposed or revealed in preparation for removal (e.g., and replacement). In many embodiments, the first dielectric in the second opening is exposed from the second side of the substrate, opposite the first side.

The first dielectric may be exposed by any suitable means. In many embodiments, the first dielectric is exposed by a directional plasma etch (e.g., using a lithographic mask). In some embodiments, the first dielectric in the first and second openings is exposed concurrently by a grinding operation and/or a planarization operation (e.g., a CMP).

Returning to FIG. 2, methods 200 continue at operation 250 by masking over the first dielectric structure, for example, before subsequently removing the first dielectric from the second opening. In many embodiments, a first dielectric structure (e.g., of the first dielectric in the first opening) is masked over from the second side of the substrate, for example, after exposing the first dielectric in both the first and second openings from the second side.

The first dielectric structure may be masked over by any suitable means and material(s), e.g., by one or more build-up layers on a first substrate side or a deposited carbon hard mask on an opposing second side.

Returning to FIG. 2, methods 200 continue with removing the first dielectric from the second opening at operation 260. The first dielectric may be removed by any suitable means, for example, by a selective, dry etch that removes the first dielectric material but retains underlying materials (such as semiconductor and gate electrode materials, as well as other dielectric materials). In many embodiments, the first dielectric includes silicon and nitrogen, and the first dielectric is removed by an etch selective to adjacent dielectrics, e.g., predominantly having silicon and oxygen.

FIG. 3C shows gate plug 151 covered by mask layer 344 and second opening 326 devoid of first dielectric material in workpiece or IC device 100, in accordance with some embodiments, for example, following a performance of operations 240, 250, and 260. Gate vias 133 couple gate structures 125 to a front-side interconnect network (e.g., extending through dielectric layer 395 and isolation 334).

Gate plug 151 is covered by layer 395 (e.g., build-up layer 395) on front side 301 of substrate 199 and by mask layer 344 on the back side 302 of substrate 199. Second opening 326 is open to back side 302, for example, to facilitate (e.g., having facilitated) the removal of (e.g., a first) dielectric material and/or to enable the deposition of (e.g., a second) dielectric material and formation of a second gate plug. Etch-stop layer 395 is at an end of second opening 326 and may have an etch selectivity with the first dielectric material.

Returning to FIG. 2, methods 200 continue at operation 270 with forming a second dielectric structure in the second opening. In many embodiments, the second dielectric structure includes a second dielectric between first and second sidewalls of the first dielectric. In some such embodiments, forming the second dielectric structure in the second opening includes depositing a conformal layer of the first dielectric (e.g., over gate sidewalls and a bottom portion between the sidewalls) and depositing a second dielectric over, on, and between the layer of the first dielectric. The conformal layer of the first dielectric may form a barrier, such as a hermetic liner, including on the gate sidewall. As such, the conformal layer may be formed with appropriate control, of suitable material(s), and to a sufficient thickness to ensure protection of the gate structure. The conformal layer may be over any and all exposed surface(s) of the opening, including but not limited to the gate sidewall. In some embodiments, the conformal layer is deposited by an atomic layer deposition (ALD), which may provide both satisfactory conformality and precise control of layer thickness. Other means of deposition may be used. The deposition may form of a liner layer as described of layer(s) 157, 158 at least at FIG. 1A. For example, a conformal liner layer of silicon and nitrogen may be deposited to a thickness of less than 4 nm. In some embodiments, a conformal liner layer of silicon and nitrogen may be deposited, e.g., by an ALD, to a thickness of 2 or 3 nm.

Forming the second dielectric structure may continue with filling the opening with a dielectric or other insulator material over the conformal layer. This bulk insulator material is advantageously a low-K dielectric material. To maximize the benefit of the low-K dielectric material, for example, in reducing parasitics between transistors, the bulk low-K dielectric material may be grown much thicker than the conformal liner layer. In some embodiments, the insulator material is grown or deposited to a thickness more than twice the thickness of the conformal layer. In some such embodiments, the insulator material is grown to a thickness more than ten times the thickness of the conformal layer, which may be necessary to allow space for the generation of sufficient strain. For example, in some embodiments, the second dielectric includes silicon and oxygen to a thickness of 10 nm. In some embodiments, the second dielectric has an atomic composition of at least 40% silicon, at least 40% oxygen, and less than 5% nitrogen, which may provide sufficient strain and satisfactory electrical isolation.

In some embodiments, the second dielectric includes vacuum or gas, and the forming the second dielectric structure in the second opening includes depositing a layer of the first dielectric and enclosing the second dielectric (e.g., gas) in the layer of the first dielectric. For example, the second dielectric structure may include first and second sidewalls (e.g., and first and second layers) of the first dielectric around a gas (such as nitrogen and/or oxygen) of the second dielectric in a void or cavity between the first and second sidewalls of the first dielectric. The layer of the first dielectric may pinch off to enclose the gas within the layer.

The second dielectric structure may be formed to any suitable size. As described of plug 152 at FIG. 1A, the second dielectric structure is advantageously wide enough (e.g., in a dimension separating adjacent gate stacks) to provide sufficient strain and isolation, but small enough to meet device layout (e.g., area) constraints, for example, with a width shorter than a gate length.

The second dielectric structure may include a layer of the first dielectric with any suitable thickness. As described of layers 157, 158 at FIG. 1A, the layer of the first dielectric may need to be sufficiently thick (e.g., to serve as a container or barrier around the second dielectric), but a minimal thickness of the first dielectric layer may advantageously provide more space for a strain-exerting and/or low-K second dielectric between adjacent gate stacks. In some embodiments, the first dielectric layer in the second dielectric structure has a thickness of approximately 2 nm. In some embodiments, the first dielectric layer in the second dielectric structure has a thickness of 3 nm or more, e.g., to protect against oxidation, etc., of gate stack metals.

FIG. 3D illustrates gate plug 151 separating gate structures 125A and gate plug 152 (with dielectric structure 153) separating gate structures 125B, in workpiece or device 100, in accordance with some embodiments, for example, following a performance of operation 270. Gate plug 152 includes dielectric structure 153 within layer(s) 157, 158, which are open to back side 302, which may indicate a method of formation. In the embodiment of FIG. 3D, plug 152 includes silicon and nitrogen at layer(s) 157, 158 (and sidewalls 155, 156) and silicon and oxygen at centerline CL.

FIG. 3E shows gate plug 151 separating gate structures 125A and gate plug 152 (with cavity 154) separating gate structures 125B, in workpiece or device 100, in accordance with some embodiments, for example, following a performance of operation 270. Gate plug 152 includes cavity 154 within layer(s) 157, 158, which pinch off at seam 159 in an aperture of layer 195 on back side 302, which may indicate a method of formation. In the embodiment of FIG. 3D, cavity 154 includes a gas (e.g., nitrogen and/or oxygen) at centerline CL, between layer(s) 157, 158 and sidewalls 155, 156.

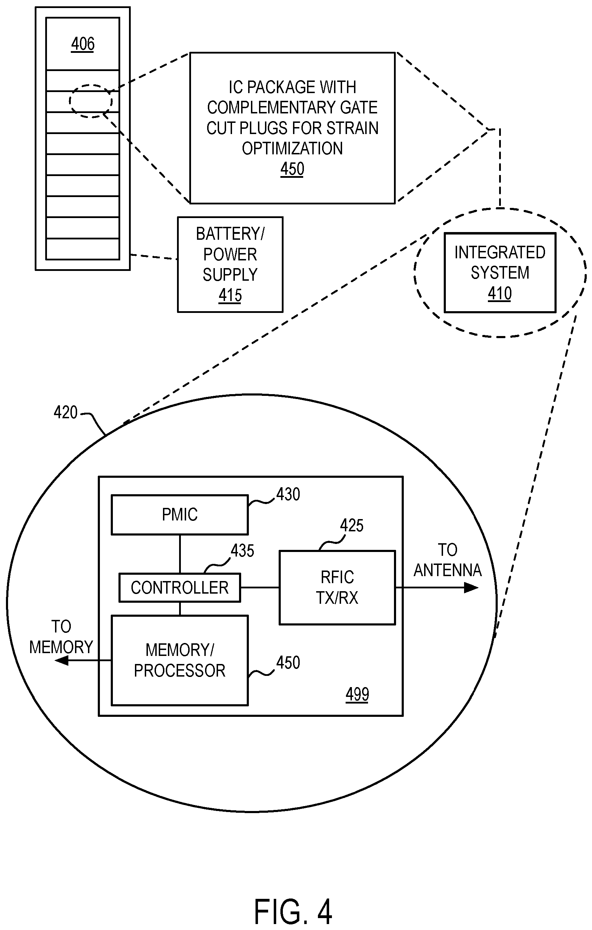

FIG. 4 illustrates a diagram of an example data server machine 406 employing an IC device having complementary gate plugs providing complementary strains between gate structures, in accordance with some embodiments. Server machine 406 may be any commercial server, for example, including any number of high-performance computing platforms disposed within a rack and networked together for electronic data processing, which in the exemplary embodiment includes one or more devices 450 having complementary gate plugs providing complementary strains between gate structures.

Also as shown, server machine 406 includes a battery and/or power supply 415 to provide power to devices 450, and to provide, in some embodiments, power delivery functions such as power regulation. Devices 450 may be deployed as part of a package-level integrated system 410. Integrated system 410 is further illustrated in the expanded view 420. In the exemplary embodiment, devices 450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 450 is a microprocessor including a static RAM (SRAM) cache memory. As shown, device 450 may be an IC device having complementary gate plugs providing complementary strains between gate structures, as discussed herein. Device 450 may be further coupled to (e.g., communicatively coupled to) a board, an interposer, or a substrate 499 along with, one or more of a power management IC (PMIC) 430, RF (wireless) IC (RFIC) 425 including a wideband RF (wireless) transmitter and/or receiver (TX/RX) (e.g., including a digital baseband and an analog front end module further includes a power amplifier on a transmit path and a low noise amplifier on a receive path), and a controller 435 thereof. In some embodiments, RFIC 425, PMIC 430, controller 435, and device 450 include having complementary gate plugs providing complementary strains between gate structures.

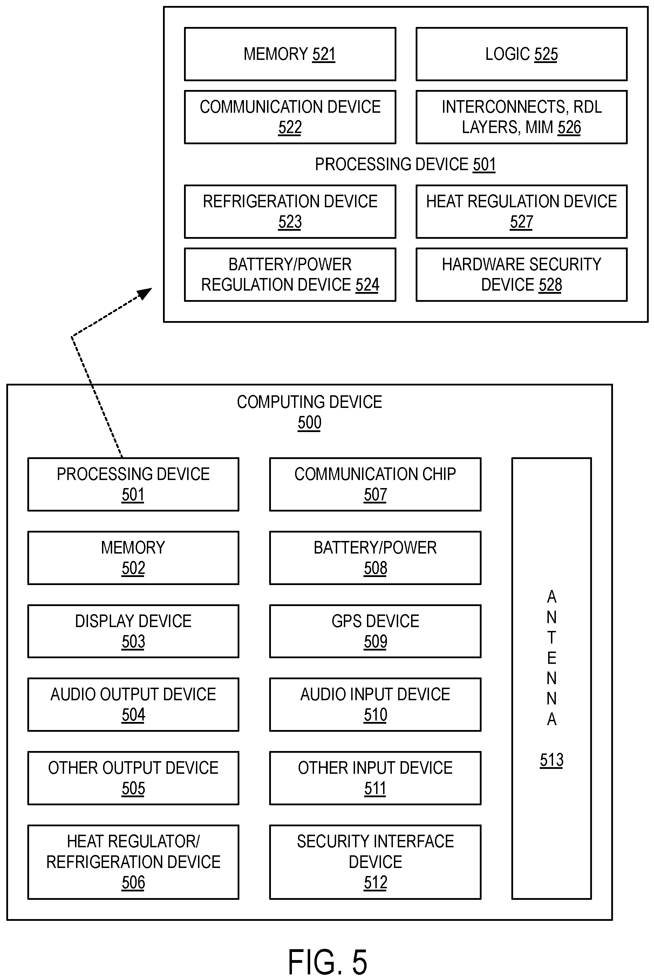

FIG. 5 is a block diagram of an example computing device 500, in accordance with some embodiments. For example, one or more components of computing device 500 may include any of the devices or structures discussed herein. A number of components are illustrated in FIG. 5 as being included in computing device 500, but any one or more of these components may be omitted or duplicated, as suitable for the application. In some embodiments, some or all of the components included in computing device 500 may be attached to one or more printed circuit boards (e.g., a motherboard). In some embodiments, various ones of these components may be fabricated onto a single system-on-a-chip (SoC) die. Additionally, in various embodiments, computing device 500 may not include one or more of the components illustrated in FIG. 5, but computing device 500 may include interface circuitry for coupling to the one or more components. For example, computing device 500 may not include a display device 503, but may include display device interface circuitry (e.g., a connector and driver circuitry) to which display device 503 may be coupled. In another set of examples, computing device 500 may not include an audio output device 504, other output device 505, global positioning system (GPS) device 509, audio input device 510, or other input device 511, but may include audio output device interface circuitry, other output device interface circuitry, GPS device interface circuitry, audio input device interface circuitry, audio input device interface circuitry, to which audio output device 504, other output device 505, GPS device 509, audio input device 510, or other input device 511 may be coupled.

Computing device 500 may include a processing device 501 (e.g., one or more processing devices). As used herein, the term "processing device" or "processor" indicates a device that processes electronic data from registers and/or memory to transform that electronic data into other electronic data that may be stored in registers and/or memory. Processing device 501 may include a memory 521, a communication device 522, a refrigeration device 523, a battery/power regulation device 524, logic 525, interconnects 526 (i.e., optionally including redistribution layers (RDL) or metal-insulator-metal (MIM) devices), a heat regulation device 527, and a hardware security device 528.

Processing device 501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 500 may include a memory 502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 502 includes memory that shares a die with processing device 501. This memory may be used as cache memory and may include embedded dynamic random-access memory (eDRAM) or spin transfer torque magnetic random-access memory (STT-MRAM).

Computing device 500 may include a heat regulation/refrigeration device 506. Heat regulation/refrigeration device 506 may maintain processing device 501 (and/or other components of computing device 500) at a predetermined low temperature during operation.

In some embodiments, computing device 500 may include a communication chip 507 (e.g., one or more communication chips). For example, the communication chip 507 may be configured for managing wireless communications for the transfer of data to and from computing device 500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 507 may operate in accordance with other wireless protocols in other embodiments. Computing device 500 may include an antenna 513 to facilitate wireless communications and/or to receive other wireless communications (such as AM or FM radio transmissions).

In some embodiments, communication chip 507 may manage wired communications, such as electrical, optical, or any other suitable communication protocols (e.g., the Ethernet). As noted above, communication chip 507 may include multiple communication chips. For instance, a first communication chip 507 may be dedicated to shorter-range wireless communications such as Wi-Fi or Bluetooth, and a second communication chip 507 may be dedicated to longer-range wireless communications such as GPS, EDGE, GPRS, CDMA, WiMAX, LTE, EV-DO, or others. In some embodiments, a first communication chip 507 may be dedicated to wireless communications, and a second communication chip 507 may be dedicated to wired communications.

Computing device 500 may include battery/power circuitry 508. Battery/power circuitry 508 may include one or more energy storage devices (e.g., batteries or capacitors) and/or circuitry for coupling components of computing device 500 to an energy source separate from computing device 500 (e.g., AC line power).

Computing device 500 may include a display device 503 (or corresponding interface circuitry, as discussed above). Display device 503 may include any visual indicators, such as a heads-up display, a computer monitor, a projector, a touchscreen display, a liquid crystal display (LCD), a light-emitting diode display, or a flat panel display, for example.

Computing device 500 may include an audio output device 504 (or corresponding interface circuitry, as discussed above). Audio output device 504 may include any device that generates an audible indicator, such as speakers, headsets, or earbuds, for example.

Computing device 500 may include an audio input device 510 (or corresponding interface circuitry, as discussed above). Audio input device 510 may include any device that generates a signal representative of a sound, such as microphones, microphone arrays, or digital instruments (e.g., instruments having a musical instrument digital interface (MIDI) output).

Computing device 500 may include a GPS device 509 (or corresponding interface circuitry, as discussed above). GPS device 509 may be in communication with a satellite-based system and may receive a location of computing device 500, as known in the art.

Computing device 500 may include other output device 505 (or corresponding interface circuitry, as discussed above). Examples of the other output device 505 may include an audio codec, a video codec, a printer, a wired or wireless transmitter for providing information to other devices, or an additional storage device.

Computing device 500 may include other input device 511 (or corresponding interface circuitry, as discussed above). Examples of the other input device 511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 500 may include a security interface device 512. Security interface device 512 may include any device that provides security measures for computing device 500 such as intrusion detection, biometric validation, security encode or decode, access list management, malware detection, or spyware detection.

Computing device 500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-5. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a first dielectric structure including opposing first and second sidewalls and silicon and nitrogen at the first and second sidewalls and at a centerline therebetween, the first sidewall on a first gate stack over a first stack of first channel material layers of a first conductivity type, the second sidewall on a second gate stack over a second stack of the first channel material layers, the first and second gate stacks including a first gate electrode material between the first channel material layers, and a second dielectric structure including opposing third and fourth sidewalls and silicon and nitrogen at the third and fourth sidewalls, the second dielectric structure including a void or a third dielectric structure therebetween, the third dielectric structure including silicon and oxygen, the third sidewall on a third gate stack over a third stack of second channel material layers, the fourth sidewall on a fourth gate stack over a fourth stack of the second channel material layers, the third and fourth gate stacks including a second gate electrode material between the second channel material layers of a second conductivity type, complementary to the first conductivity type.

In one or more second embodiments, further to the first embodiments, the first dielectric structure includes an atomic composition at the first and second sidewalls of at least thirty percent silicon, at least thirty percent nitrogen, and less than five percent oxygen.

In one or more third embodiments, further to the first or second embodiments, the atomic composition is a first atomic composition, and the first dielectric structure includes a second atomic composition at the centerline of at least thirty percent silicon, at least thirty percent nitrogen, and less than five percent oxygen.

In one or more fourth embodiments, further to the first through third embodiments, the atomic composition is a first atomic composition, and the second dielectric structure includes a second atomic composition at the third and fourth sidewalls of at least thirty percent silicon, at least thirty percent nitrogen, and less than five percent oxygen.

In one or more fifth embodiments, further to the first through fourth embodiments, a first dielectric layer of the second dielectric structure includes the third sidewall, a second dielectric layer of the second dielectric structure includes the fourth sidewall, and the first and second dielectric layers enclose the void.

In one or more sixth embodiments, further to the first through fifth embodiments, a first dielectric layer of the second dielectric structure includes the third sidewall, a second dielectric layer of the second dielectric structure includes the fourth sidewall, the centerline is a first centerline, and the third dielectric structure includes an atomic composition at a second centerline between the third and fourth sidewalls of at least thirty percent silicon, at least thirty percent oxygen, and less than five percent nitrogen.

In one or more seventh embodiments, further to the first through sixth embodiments, a fourth dielectric structure includes silicon and nitrogen at opposing fifth and sixth sidewalls and a cavity or a fifth dielectric structure therebetween, the fifth dielectric structure includes silicon and oxygen, the fifth sidewall is on the second gate stack, and the sixth sidewall is on the third gate stack.

In one or more eighth embodiments, further to the first through seventh embodiments, the centerline is a first centerline, a fourth dielectric structure includes silicon and nitrogen at opposing fifth and sixth sidewalls and at a second centerline therebetween, the fifth sidewall is on the second gate stack, and the sixth sidewall is on the third gate stack.

In one or more ninth embodiments, further to the first through eighth embodiments, the centerline is a first centerline, a fourth dielectric structure includes silicon and nitrogen at opposing fifth and sixth sidewalls and at a second centerline therebetween, the fifth sidewall is on the second gate stack, the sixth sidewall is on the third gate stack, a fifth dielectric structure is between and in contact with fifth and sixth gate stacks over fifth and sixth stacks of the first channel material layers, the fifth dielectric structure including silicon and nitrogen at opposing seventh and eighth sidewalls and at a third centerline therebetween, a sixth dielectric structure is between and in contact with seventh and eighth gate stacks over seventh and eighth stacks of the second channel material layers, the sixth dielectric structure including silicon and nitrogen at opposing ninth and tenth sidewalls and a cavity or a seventh dielectric structure therebetween, the seventh dielectric structure including silicon and oxygen, an eighth dielectric structure includes silicon and nitrogen at opposing eleventh and twelfth sidewalls and a space or a ninth dielectric structure therebetween, the ninth dielectric structure including silicon and oxygen, the eleventh sidewall is on the sixth gate stack, and the twelfth sidewall is on the seventh gate stack.

In one or more tenth embodiments, an apparatus includes first and second gate structures extending in a first direction, over adjacent stacks of first channel material layers extending in a second direction orthogonal to the first direction and coupled to n-type source and drain bodies, third and fourth gate structures extending in the first direction, over adjacent stacks of second channel material layers extending in the second direction and coupled to p-type source and drain bodies, a first dielectric structure including opposing first and second sidewalls and silicon and nitrogen at the first and second sidewalls and at a centerline therebetween, the first sidewall on the first gate structure, the second sidewall on the second gate structure, and a second dielectric structure including opposing third and fourth sidewalls, silicon and nitrogen at the third and fourth sidewalls, and a void or a third dielectric structure therebetween, the third dielectric structure including silicon and oxygen, the third sidewall on the third gate structure, the fourth sidewall on the fourth gate structure.

In one or more eleventh embodiments, further to the tenth embodiments, a first dielectric layer of the second dielectric structure includes the third sidewall, a second dielectric layer of the second dielectric structure includes the fourth sidewall, and the first and second dielectric layers enclose the void.

In one or more twelfth embodiments, further to the tenth or eleventh embodiments, a first dielectric layer of the second dielectric structure includes the third sidewall, a second dielectric layer of the second dielectric structure includes the fourth sidewall, the centerline is a first centerline, and the third dielectric structure includes an atomic composition at a second centerline between the third and fourth sidewalls of at least thirty percent silicon, at least thirty percent oxygen, and less than five percent nitrogen.

In one or more thirteenth embodiments, further to the tenth through twelfth embodiments, the first, second, third, and fourth gate structures are on an axis extending in the first direction, and a fourth dielectric structure is on and between the second and third gate structures.

In one or more fourteenth embodiments, further to the tenth through thirteenth embodiments, the fourth dielectric structure includes silicon and nitrogen at opposing fifth and sixth sidewalls and a cavity or a fifth dielectric structure therebetween, the fifth dielectric structure including silicon and oxygen, the fifth sidewall is on the second gate structure, and the sixth sidewall is on the third gate structure.

In one or more fifteenth embodiments, further to the tenth through fourteenth embodiments, the fourth dielectric structure includes silicon and nitrogen at opposing fifth and sixth sidewalls and at a third centerline therebetween, the fifth sidewall is on the second gate structure, and the sixth sidewall is on the third gate structure.

In one or more sixteenth embodiments, a method includes forming a first opening in a first gate stack over a substrate and between first and second stacks of first channel material layers of a first conductivity type, forming a second opening in a second gate stack over the substrate and between third and fourth stacks of second channel material layers of a second conductivity type complementary to the first conductivity type, depositing a first dielectric in the first and second openings from a first side of the substrate, the first dielectric including silicon and nitrogen, a first dielectric structure including the first dielectric in the first opening, exposing the first dielectric in the second opening from a second side of the substrate, opposite the first side, removing the first dielectric from the second opening, and forming a second dielectric structure in the second opening, the second dielectric structure including a second dielectric between first and second sidewalls of the first dielectric.

In one or more seventeenth embodiments, further to the sixteenth embodiments, the forming the second dielectric structure in the second opening includes depositing a layer of the first dielectric and enclosing the second dielectric in the layer of the first dielectric, the second dielectric including vacuum or gas in a void between the first and second sidewalls of the first dielectric.

In one or more eighteenth embodiments, further to the sixteenth or seventeenth embodiments, the forming the second dielectric structure in the second opening includes depositing a layer of the first dielectric and depositing the second dielectric on the layer of the first dielectric, the second dielectric including silicon and oxygen.

In one or more nineteenth embodiments, further to the sixteenth through eighteenth embodiments, the exposing the first dielectric in the second opening from the second side of the substrate exposes the first dielectric in the first opening from the second side of the substrate, the method also including masking over the first dielectric structure before the removing the first dielectric from the second opening.

In one or more twentieth embodiments, further to the sixteenth through nineteenth embodiments, the depositing the first dielectric in the first and second openings from the first side of the substrate includes depositing the first dielectric with an atomic composition of at least thirty percent silicon, at least thirty percent nitrogen, and less than five percent oxygen.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a first dielectric structure comprising opposing first and second sidewalls and silicon and nitrogen at the first and second sidewalls and at a centerline therebetween, the first sidewall on a first gate stack over a first stack of first channel material layers of a first conductivity type, the second sidewall on a second gate stack over a second stack of the first channel material layers, the first and second gate stacks comprising a first gate electrode material between the first channel material layers; and
a second dielectric structure comprising opposing third and fourth sidewalls and silicon and nitrogen at the third and fourth sidewalls, the second dielectric structure comprising a void or a third dielectric structure therebetween, the third dielectric structure comprising silicon and oxygen, the third sidewall on a third gate stack over a third stack of second channel material layers, the fourth sidewall on a fourth gate stack over a fourth stack of the second channel material layers, the third and fourth gate stacks comprising a second gate electrode material between the second channel material layers of a second conductivity type, complementary to the first conductivity type.

2. The apparatus of claim 1, wherein the first dielectric structure comprises an atomic composition at the first and second sidewalls of at least thirty percent silicon, at least thirty percent nitrogen, and less than five percent oxygen.

3. The apparatus of claim 2, wherein the atomic composition is a first atomic composition, and the first dielectric structure comprises a second atomic composition at the centerline of at least thirty percent silicon, at least thirty percent nitrogen, and less than five percent oxygen.

4. The apparatus of claim 2, wherein the atomic composition is a first atomic composition, and the second dielectric structure comprises a second atomic composition at the third and fourth sidewalls of at least thirty percent silicon, at least thirty percent nitrogen, and less than five percent oxygen.

5. The apparatus of any of claims 1 to 4, wherein a first dielectric layer of the second dielectric structure comprises the third sidewall, a second dielectric layer of the second dielectric structure comprises the fourth sidewall, and the first and second dielectric layers enclose the void.

6. The apparatus of any of claims 1 to 4, wherein a first dielectric layer of the second dielectric structure comprises the third sidewall, a second dielectric layer of the second dielectric structure comprises the fourth sidewall, the centerline is a first centerline, and the third dielectric structure comprises an atomic composition at a second centerline between the third and fourth sidewalls of at least thirty percent silicon, at least thirty percent oxygen, and less than five percent nitrogen.

7. The apparatus any of claims 1 to 6, wherein a fourth dielectric structure comprises silicon and nitrogen at opposing fifth and sixth sidewalls and a cavity or a fifth dielectric structure therebetween, the fifth dielectric structure comprises silicon and oxygen, the fifth sidewall is on the second gate stack, and the sixth sidewall is on the third gate stack.

8. The apparatus of any of claims 1 to 7, wherein the centerline is a first centerline, a fourth dielectric structure comprises silicon and nitrogen at opposing fifth and sixth sidewalls and at a second centerline therebetween, the fifth sidewall is on the second gate stack, and the sixth sidewall is on the third gate stack.

9. The apparatus of any of claims 1 to 7, wherein:
the centerline is a first centerline;
a fourth dielectric structure comprises silicon and nitrogen at opposing fifth and sixth sidewalls and at a second centerline therebetween;
the fifth sidewall is on the second gate stack;
the sixth sidewall is on the third gate stack;
a fifth dielectric structure is between and in contact with fifth and sixth gate stacks over fifth and sixth stacks of the first channel material layers, the fifth dielectric structure comprising silicon and nitrogen at opposing seventh and eighth sidewalls and at a third centerline therebetween;
a sixth dielectric structure is between and in contact with seventh and eighth gate stacks over seventh and eighth stacks of the second channel material layers, the sixth dielectric structure comprising silicon and nitrogen at opposing ninth and tenth sidewalls and a cavity or a seventh dielectric structure therebetween, the seventh dielectric structure comprising silicon and oxygen;
an eighth dielectric structure comprises silicon and nitrogen at opposing eleventh and twelfth sidewalls and a space or a ninth dielectric structure therebetween, the ninth dielectric structure comprising silicon and oxygen;
the eleventh sidewall is on the sixth gate stack; and
the twelfth sidewall is on the seventh gate stack.

10. The apparatus any of claims 1 to 9, further comprising:
a device comprising the first dielectric structure, the first gate stack, the first stack of first channel material layers, the second gate stack, the second stack of the first channel material layers, the second dielectric structure, the third gate stack, the third stack of second channel material layers, the fourth gate stack, and the fourth stack of the second channel material layers; and
a power supply coupled to the device.

11. A method, comprising:
forming a first opening in a first gate stack over a substrate and between first and second stacks of first channel material layers of a first conductivity type;
forming a second opening in a second gate stack over the substrate and between third and fourth stacks of second channel material layers of a second conductivity type complementary to the first conductivity type;
depositing a first dielectric in the first and second openings from a first side of the substrate, the first dielectric comprising silicon and nitrogen, a first dielectric structure comprising the first dielectric in the first opening;
exposing the first dielectric in the second opening from a second side of the substrate, opposite the first side;
removing the first dielectric from the second opening; and
forming a second dielectric structure in the second opening, the second dielectric structure comprising a second dielectric between first and second sidewalls of the first dielectric.

12. The method of claim 11, wherein forming the second dielectric structure in the second opening comprises depositing a layer of the first dielectric and enclosing the second dielectric in the layer of the first dielectric, the second dielectric comprising vacuum or gas in a void between the first and second sidewalls of the first dielectric.

13. The method of claim 11, wherein forming the second dielectric structure in the second opening comprises depositing a layer of the first dielectric and depositing the second dielectric on the layer of the first dielectric, the second dielectric comprising silicon and oxygen.

14. The method of any of claims 11 to 13, wherein exposing the first dielectric in the second opening from the second side of the substrate exposes the first dielectric in the first opening from the second side of the substrate, the method further comprising masking over the first dielectric structure before the removing the first dielectric from the second opening.

15. The method of any of claims 11 to 13, wherein depositing the first dielectric in the first and second openings from the first side of the substrate comprises depositing the first dielectric with an atomic composition of at least thirty percent silicon, at least thirty percent nitrogen, and less than five percent oxygen.
